# EUROPEAN PATENT APPLICATION

(11) **EP 4 510 792 A1**
(43) Date of publication of application: **19.02.2025**
(21) Application number: 23820000.0
(22) Date of filing: 10.05.2023
(51) Int. Cl.: H05K 7/20, H05K 5/00

(54) **FRAME STRUCTURE AND ELECTRONIC DEVICE INCLUDING SAME**

(30) Priority: 10.06.2022 KR 20220070637; 22.08.2022 KR 20220105103
(71) Applicant: Samsung Electronics Co., Ltd., Suwon-si, Gyeonggi-do 16677 (KR)
(72) Inventor: PARK, Jongkil, Suwon-si Gyeonggi-do 16677 (KR); AHN, Joseph, Suwon-si Gyeonggi-do 16677 (KR); MOON, Hongki, Suwon-si Gyeonggi-do 16677 (KR); YUN, Hajoong, Suwon-si Gyeonggi-do 16677 (KR)
(74) Representative: HGF
(86) International application number: PCT/KR2023/006312
(87) International publication number: WO 2023/239064

(57) **Abstract**

This electronic device may comprise a frame structure and a housing. The frame structure may include a plate, a plurality of first channels, and a plurality of second channels. The plurality of first channels and the plurality of second channels may form a closed loop in the plate. The plurality of first channels may include a first liquid region and a first gas region.

## Description

### TECHNICAL FIELD

The disclosure relates to a frame structure and an electronic device including the frame structure.

### BACKGROUND ART

Cooling structures are being developed to reduce heat generated from electronic devices. For example, a cooling structure may reduce the temperature of an electronic device by utilizing phase changes in a working fluid. The above description is information the inventor(s) acquired during the course of conceiving the disclosure, or already possessed at the time, and is not necessarily art publicly known before the present application was filed.

### DISCLOSURE OF THE INVENTION

### TECHNICAL SOLUTIONS

According to an embodiment, an electronic device includes a frame structure and a housing configured to accommodate the frame structure, wherein the frame structure may include a plate including a first length, a second length, and a thickness, a plurality of first channels recessed in a surface of the plate in a thickness direction, arranged in a first longitudinal direction of the plate, the plurality of first channels being configured to guide a flow of a working fluid, and a plurality of second channels recessed in the surface of the plate in the thickness direction, arranged in a second longitudinal direction of the plate, the plurality of second channels being configured to guide the flow of the working fluid, wherein the plurality of first channels are connected to the plurality of second channels to form a closed loop within the plate, and wherein the plurality of first channels may include a first liquid region configured to guide the working fluid in a liquid phase and a first gas region configured to guide the working fluid in a gas phase.

According to an embodiment, a frame structure may be disposed in an electronic device. The frame structure includes a plate including a first length, a second length, and a thickness, a plurality of first channels recessed in one surface of the plate in a thickness direction, arranged in a first longitudinal direction of the plate, the plurality of first channels configured to guide a flow of a working fluid and a plurality of second channels recessed in the surface of the plate in the thickness direction, arranged in a second longitudinal direction of the plate, and the plurality of second channels being configured to guide the flow of the working fluid, wherein the plurality of first channels are connected to the plurality of second channels to form a closed loop within the plate, and wherein the plurality of first channels may include a first liquid region configured to guide the working fluid in a liquid phase and a first gas region configured to guide the working fluid in a gas phase.

### BRIEF DESCRIPTION OF THE DRAWINGS

The foregoing and other aspects, features, and advantages of embodiments in the disclosure will become apparent from the following detailed description with reference to the accompanying drawings.
FIG. 1 is a block diagram of an electronic device in a network environment, according to an embodiment.
FIG. 2A is a perspective view of an electronic device in one direction, according to an embodiment.
FIG. 2B is a perspective view of the electronic device in another direction, according to an embodiment.
FIG. 2C is an exploded perspective view of the electronic device according to an embodiment.
FIG. 3 is an exploded perspective view of an electronic device according to an embodiment.
FIG. 4 is a plan view of a frame structure of the electronic device, according to an embodiment.
FIG. 5 is a plan view of channels of a frame structure, according to an embodiment.
FIG. 6 is a cross-sectional view taken along a line 6-6 of the frame structure of FIG. 5, according to an embodiment.
FIG. 7 is a cross-sectional view of an electronic device including the frame structure of FIG. 6, according to an embodiment.
FIG. 8 is a cross-sectional view of the frame structure of FIG. 5, according to an embodiment.
FIG. 9 is a plan view of the frame structure of FIG. 5, according to an embodiment.
FIG. 10 is an exploded perspective view of an electronic device, according to an embodiment.
FIG. 11 is a plan view of a frame structure of the electronic device, according to an embodiment.
FIG. 12 is a diagram illustrating a frame structure in a first state of an electronic device, according to an embodiment.
FIG. 13 is a diagram illustrating the frame structure when the electronic device is in a second state, according to an embodiment.

### BEST MODE FOR CARRYING OUT THE INVENTION

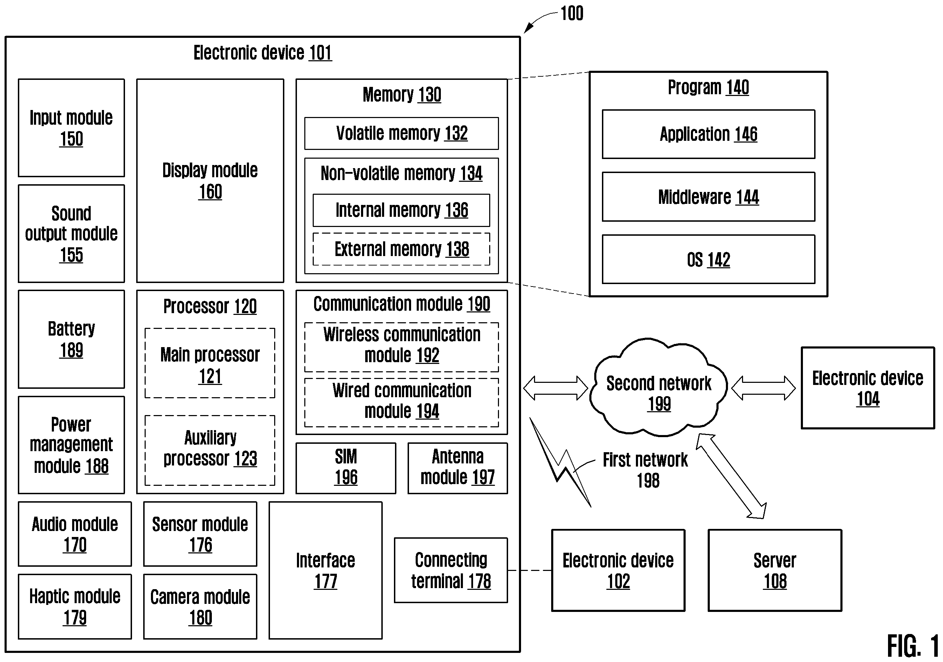

FIG. 1 is a block diagram of an electronic device in a network environment, according to an embodiment.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the components may be omitted from the electronic device 101, or one or more other components may be added to the electronic device 101. In some embodiments, some (e.g., the sensor module 176, the camera module 180, or the antenna module 197) of the components may be integrated as a single component (e.g., the display module 160).

The processor 120 may execute, for example, software (e.g., the program 140) to control at least one other component (e.g., a hardware or software component) of the electronic device 101 connected to the processor 120 and may perform various data processing or computations. According to an embodiment, as at least a portion of data processing or computations, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a portion of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An AI model may be generated through machine learning. Such learning may be performed by, for example, the electronic device 101, in which an AI model is executed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The AI model may additionally or alternatively include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored as software in the memory 130, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a display, a hologram device, or a projector and a control circuit to control a corresponding one of the display, the hologram device, and the projector. According to an embodiment, the display module 160 may include a touch sensor adapted to detect a touch or a pressure sensor adapted to measure an intensity of a force incurred by the touch.

The audio module 170 may convert a sound into an electric signal or vice versa. According to an embodiment, the audio module 170 may obtain the sound via the input module 150 or output the sound via the sound output module 155 or an external electronic device (e.g., an electronic device 102, such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101 and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus, which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell, which is not rechargeable, a secondary cell, which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., an AP) and that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local region network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., a LAN or a wide region network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., an mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a portion of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and exchange signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more external electronic devices (e.g., the external devices 102 and 104, and the server 108). For example, when the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra low-latency services using, e.g., distributed computing or MEC. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., a smart home, a smart city, a smart car, or healthcare) based on 5G communication technology or IoT-related technology.

The electronic device according to one or more embodiments may be various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, "A or B," "at least one of A and B," "at least one of A or B," "A, B or C," "at least one of A, B and C," and "at least one of A, B, or C," may include any one of the items listed together in the corresponding one of the phrases, or all possible combinations thereof. Terms such as "1st" and "2nd," or "first" and "second" may be used to simply distinguish a corresponding component from other components, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to embodiments disclosed herein may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

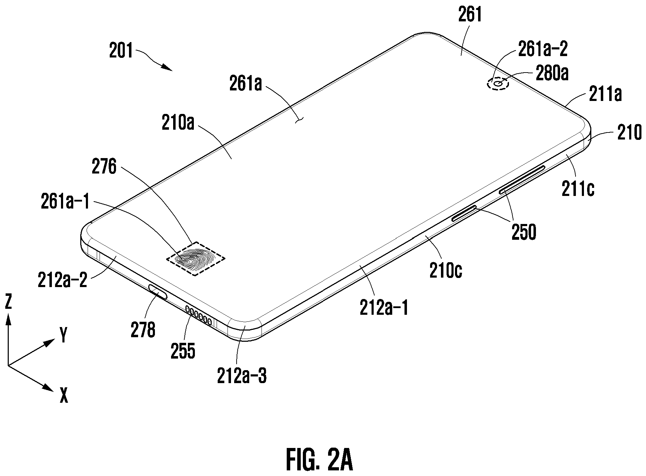

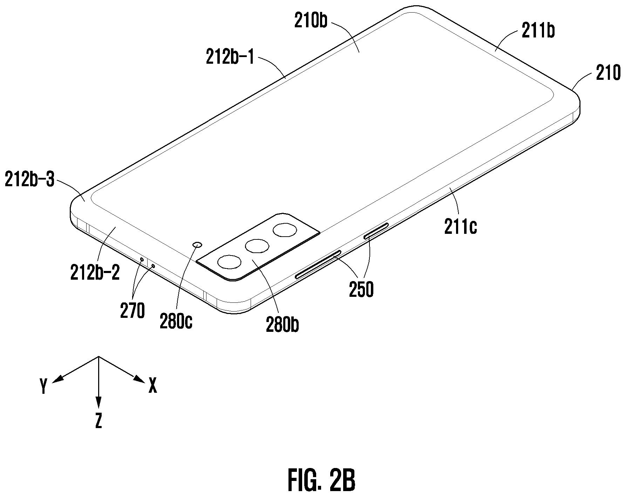

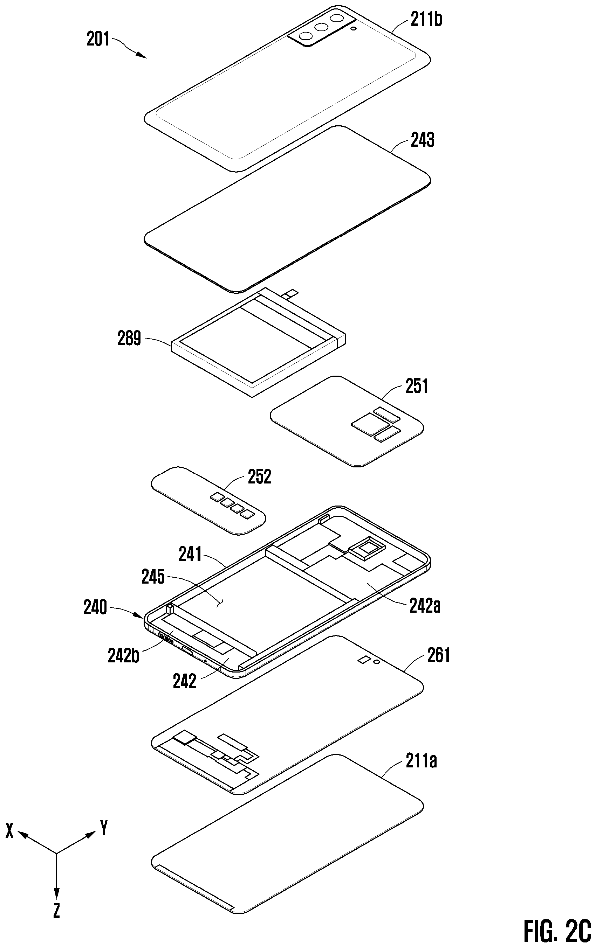

FIG. 2A is a perspective view of an electronic device in one direction, according to an embodiment. FIG. 2B is a perspective view of the electronic device in another direction, according to an embodiment. FIG. 2C is an exploded perspective view of the electronic device, according to an embodiment.

Referring to FIGS. 2A to 2C, .an electronic device 201 (e.g., the electronic device 101 of FIG. 1) may include a housing 210 including a first surface 210a (e.g., a front surface), a second surface 210b (e.g., a rear surface), and a third surface 210c (e.g., a side surface) enclosing a space between the first surface 210a and the second surface 210b.

In an embodiment, the first surface 210a may be formed by a first plate 211a of which at least a portion is substantially transparent. For example, the first plate 211a may include a polymer plate or a glass plate including at least one coating layer. In an embodiment, the second surface 210b may be formed by a second plate 211b that is substantially opaque. For example, the second plate 211b may be formed of coated or tinted glass, ceramic, polymer, metal (e.g., aluminum, stainless steel (STS), or magnesium), or a combination thereof. In an embodiment, the third surface 210c may be formed by a frame 211c that is coupled to the first plate 211a and the second plate 211b and that includes a metal and/or a polymer. In an embodiment, the second plate 211b and the frame 211c may be integrated and seamlessly formed. In an embodiment, the second plate 211b and the frame 211c may be formed of substantially the same material (e.g., aluminum).

In an embodiment, the first plate 211a may include a plurality of first periphery regions 212a-1. The plurality of first periphery regions 212a-1 may face the second plate 211b from at least a partial region of the first surface 210a. A plurality of first periphery regions 212a-1 may be in contact with the frame 211c. The plurality of first periphery regions 212a-1 may extend in one direction (e.g., +/-Y direction). The first plate 211a may include a plurality of second periphery regions 212a-2. The plurality of second periphery regions 212a-2 may face the second plate 211b from at least a partial region of the first surface 210a. A plurality of second periphery regions 212a-2 may be in contact with the frame 211c. The plurality of second periphery areas 212a-2 may extend in a direction (e.g., the +/-X direction) different from an extending direction (e.g., the +/-Y direction) of the plurality of first periphery areas 212a-1. The first plate 211a may include a plurality of third periphery regions 212a-3. The plurality of third periphery regions 212a-3 may face the second plate 211b from at least a partial region of the first surface 210a. A plurality of third periphery regions 212a-3 may be in contact with the frame 211c. The plurality of third periphery regions 212a-3 may be disposed between the plurality of first periphery regions 212a-1 and the plurality of second periphery regions 212a-2.

**In** an embodiment, the second plate 211b may include a plurality of fourth periphery regions 212b-1. The plurality of fourth periphery regions 212b-1 may face the first plate 211a from at least a partial region of the second surface 210b. A plurality of fourth periphery regions 212b-1 may be in contact with the frame 211c. The plurality of fourth periphery regions 212b-1 may extend in one direction (e.g., +/-Y direction). The second plate 211b may include a plurality of fifth periphery regions 212b-2. The plurality of fifth periphery regions 212b-2 may face the first plate 211a from at least a partial region of the second surface 210b. A plurality of fifth periphery regions 212b-2 may be in contact with the frame 211c. The plurality of fifth periphery regions 212b-2 may extend in a direction (e.g., +/-X direction) different from an extending direction (e.g., +/-Y direction) of the plurality of fourth periphery regions 212b-1. The second plate 211b may include a plurality of sixth periphery regions 212b-3. The plurality of sixth periphery regions 212b-3 may face the first plate 211a from at least a partial region of the second surface 210b. A plurality of sixth periphery regions 212b-3 may be in contact with the frame 211c. The plurality of sixth periphery regions 212b-3 may be disposed between the plurality of fourth periphery regions 212b-1 and the plurality of fifth periphery regions 212b-2.

In an embodiment, the electronic device 201 may include a display 261 (e.g., the display module 160 of FIG. 1). In an embodiment, the display 261 may be positioned on the first surface 210a. In an embodiment, the display 261 may be visible through at least a portion (e.g., the plurality of first periphery regions 212a-1, the plurality of second periphery regions 212a-2, and/or the plurality of third periphery regions 212a-3) of the first plate 211a. In an embodiment, the display 261 may have a shape that is substantially the same as the shape of an outer edge of the first plate 211a. In some embodiments, the periphery of the display 261 may substantially coincide with the outer edge of the first plate 211a.

In an embodiment, the display 261 may include a touch sensing circuit, a pressure sensor for measuring an intensity (pressure) of a touch, and/or a digitizer for detecting a magnetic-type stylus pen.

In an embodiment, the display 261 may include a screen display region 261a that is visually exposed to display content using pixels. In an embodiment, the screen display region 261a may include a sensing region 261a-1. The sensing region 261a-1 may overlap at least a partial region of the screen display region 261a. The sensing region 261a-1 may allow transmission of an input signal related to a sensor module 276 (e.g., the sensor module 176 of FIG. 1). The sensing region 261a-1 may display content, similarly to the screen display region 261a that does not overlap the sensing region 261a-1. For example, the sensing region 261a-1 may display the content while the sensor module 276 is not operating. At least a portion of a camera area 261a-2 may overlap the screen display area 261a. In an embodiment, the screen display area 261a may include the camera area 261a-2. The camera region 261a-2 may allow transmission of an optical signal related to a first camera module 280a (e.g., the camera module 180 of FIG. 1). At least a portion of the camera region 261a-2, that overlaps the screen display region 261a, may display content, similarly to the screen display region 261a that does not overlap the camera region 261a-2. For example, the camera region 261a-2 may display the content while the first camera module 280a is not operating.

In an embodiment, the electronic device 201 may include an audio module 270 (e.g., the audio module 170 of FIG. 1). In an embodiment, the audio module 270 may be positioned on the third surface 210c. In an embodiment, the audio module 270 may obtain sound through at least one hole.

In an embodiment, the electronic device 201 may include the sensor module 276. In an embodiment, the sensor module 276 may be positioned on the first surface 210a. The sensor module 276 may form the sensing region 261a-1 in at least a portion of the screen display region 261a. The sensor module 276 may receive an input signal transmitted through the sensing region 261a-1 and generate an electrical signal based on the received input signal. In an example, the input signal may have a designated physical quantity (e.g., heat, light, temperature, sound, pressure, or ultrasound). In an example, the input signal may include a signal related to biometric information (e.g., a fingerprint) of a user.

In an embodiment, the electronic device 201 may include a first camera module 280a (e.g., the camera module 180 of FIG. 1). In an embodiment, the first camera module 280a may be positioned on the first side 210a. In an embodiment, at least a portion of the first camera module 280a may be positioned under the display 261. In an embodiment, the first camera module 280a may receive an optical signal transmitted through the camera region 261a-2.

In an embodiment, the electronic device 201 may include a second camera module 280b (e.g., the camera module 180 of FIG. 1). The second camera module 280b may be positioned on the second surface 210b. In an embodiment, the second camera module 280b may include a plurality of camera modules (e.g., a dual camera, a triple camera, or a quad camera).

In an embodiment, the electronic device 201 may include a flash 280c. The flash 280c may be positioned on the second surface 210b. In an embodiment, the flash 280c may include a light-emitting diode or a xenon lamp.

In an embodiment, the electronic device 201 may include a sound output module 255 (e.g., the sound output module 155 of FIG. 1). In an embodiment, the sound output module 255 may be positioned on the third surface 210c. In an embodiment, the sound output module 255 may include one or more holes.

In an embodiment, the electronic device 201 may include an input module 250 (e.g., the input module 150 of FIG. 1). In an embodiment, the input module 250 may be positioned on the third surface 210c. In an embodiment, the input module 250 may include at least one key input device.

In an embodiment, the electronic device 201 may include a connecting terminal 278 (e.g., the connecting terminal 178 of FIG. 1). In an embodiment, the connecting terminal 278 may be positioned on the third surface 210c. For example, when the electronic device 201 is viewed in one direction (e.g., the +Y direction), the connecting terminal 278 may be positioned substantially in a central portion of the third surface 210c, and the sound output module 255 may be positioned on one side (e.g., a right side) with respect to the connecting terminal 278.

In an embodiment, the electronic device 201 may include a support body 240, a first circuit board 251, a second circuit board 252, and a battery 289 (e.g., the battery 189 of FIG. 1). At least a portion of the support body 240 may form the housing 210 together with the first plate 211a and the second plate 211b.

In an embodiment, the support body 240 may include a first frame structure 241, a second frame structure 243, and a plate structure 242. The first frame structure 241 may surround the periphery of the plate structure 242. The first frame structure 241 may connect the periphery of the first plate 211a and the periphery of the second plate 211b. The first frame structure 241 may enclose a space between the first plate 211a and the second plate 211b. At least a portion of the first frame structure 241 may form the third surface 210c of the electronic device 201. The second frame structure 243 may be positioned between the first frame structure 241 and the second plate 211b. The first frame structure 241 and the second frame structure 243 may at least partially form the frame 211c. The plate structure 242 may include a first portion 242a for accommodating the first circuit board 251, and a second portion 242b for accommodating the second circuit board 252. The display 261 may be positioned on one side (e.g., the lower surface or +Z-axis direction) of the plate structure 242. The first circuit board 251 and the second circuit board 252 may be positioned on the other surface (e.g., the upper surface or -Z axis direction) of the plate structure 242. In an embodiment, the plate structure 242 may include an opening 245. The opening 245 may be positioned between the first portion 242a and the second portion 242b. The opening 245 may pass through both sides of the plate structure 242. The opening 245 may accommodate the battery 289.

Meanwhile, one or more embodiments provided herein may also apply to electronic devices of various shapes/forms (e.g., a foldable electronic device, a slidable electronic device, a digital camera, a digital video camera, a tablet personal computer (PC), a notebook-shaped electronic device, and other electronic devices), in addition to the electronic device shown in FIGS. 2A to 2C.

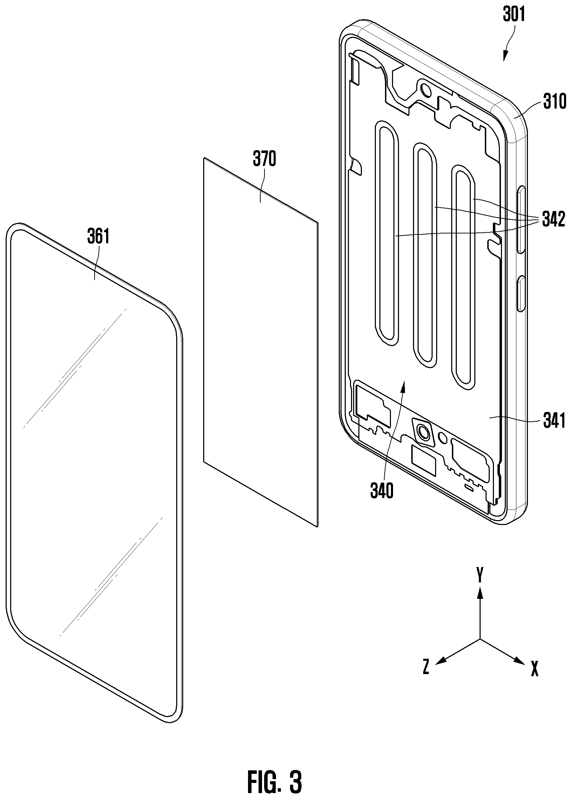

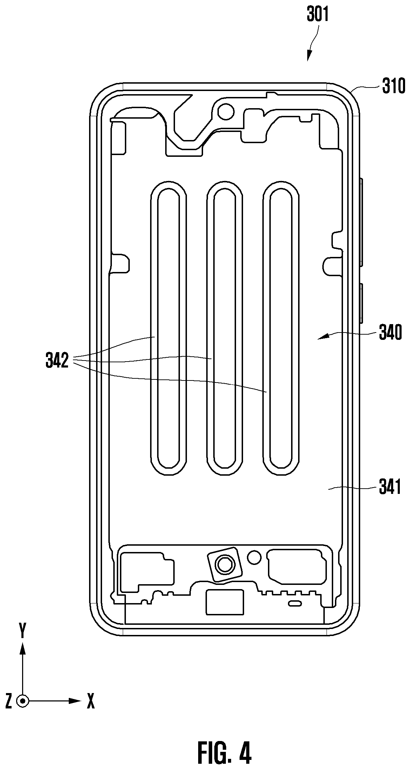

FIG. 3 is an exploded perspective view of an electronic device according to an embodiment. FIG. 4 is a plan view of a frame structure of the electronic device, according to an embodiment.

Referring to FIGS. 3 and 4, an electronic device 301 (e.g., the electronic device 201 of FIGS. 2A to 2C) may include a housing 310 (e.g., the housing 210 of FIGS. 2A to 2C), a frame structure 340 (e.g., the first frame structure 241 and/or the second frame structure 243 of FIGS. 2A to 2C) accommodated in the housing 310, a cover sheet 370 disposed on the frame structure 340 and configured to cover at least a portion of the frame structure 340, and a display 361 (e.g., the display 261 of FIGS. 2A to 2C) disposed on the cover sheet 370.

In an embodiment, the frame structure 340 may further include a plate 341. The plate 341 may have a first length (e.g., a +/-X direction length), a second length (e.g., a +/-Y direction length), and a thickness (e.g., a +/-Z direction length).

In an embodiment, the plate 341 may be formed of a metal material. The plate 341 may be formed at least partially of a non-metal material.

In an embodiment, the frame structure 340 may include a plurality of flow path structures 342 configured to guide the flow of a working fluid. The working fluid may reduce heat generated in the electronic device 301 by circulating through the plurality of flow path structures 342. For example, the working fluid may include at least one or a combination of water, ammonia, ethanol, methanol, and/or Freon^{™}. The working fluid may be determined based on the operating temperature range and/or chemical reactivity of the working fluid.

In an embodiment, the plurality of flow path structures 342 may be included in the first frame structure 241 of FIGS. 2A to 2C. In an embodiment, the plurality of flow path structures 342 may be included in the second frame structure 243 of FIGS. 2A to 2C.

In an embodiment, the plurality of flow path structures 342 may be formed integrally with the plate 341. A structure in which the plurality of flow path structures 342 is formed integrally with the plate 341 may reduce the thickness of the frame structure 340 and further reduce the thickness of the electronic device 301. The working fluid may circulate through the plurality of flow path structures 342 within the plate 341 without a circulation path with the outside of the plate 341.

In an embodiment, the plurality of flow path structures 342 may each include a recess formed in the thickness direction (e.g., +/-Z direction) of the plate 341. Implementing the plurality of flow path structures 342 in a recessed shape may increase the rigidity of the frame structure 340.

In an embodiment, the plurality of flow path structures 342 may be arranged in various shapes on the plate 341. For example, the plurality of flow path structures 342 may be arranged substantially side by side in one direction (e.g., +/-X direction) of the plate 341. According to an embodiment, an arrangement of the plurality of flow path structures 342 may increase the heat dissipation performance of the electronic device 301. According to an embodiment, the arrangement of the plurality of flow path structures 342 may dissipate heat in regions within the electronic device 301 in which a plurality of heat sources is disposed even when the plurality of heat sources is disposed at different positions within the electronic device 301. For example, heat generated from the plurality of heat sources may be spread by the flow path structures 342. A heat source may include, for example, the processor 120 of FIG. 1 (e.g., an AP/CP processor), a power amplification module (PAM), the camera module 180 of FIG. 1, the power management module 188 of FIG. 1 (e.g., a PMIC), the battery 189 of FIG. 1, the antenna module 197 of FIG. 1 (e.g., a 5G array antenna), and/or any electronic component(s) configured to generate heat.

**In** an embodiment, the electronic device 301 may not include a separate flow path structure or a separate component including the separate flow path structure between the frame structure 340 and other peripheral components (e.g., the display 361, the battery 289 of FIG. 2C, and/or other components). According to the structure described above, the frame structure 340 may have a reduced thickness (e.g., a thickness change of about 0.16 millimeters (mm) or more) compared to a structure in which a separate flow path structure or a separate component including the separate flow path structure is placed within the electronic device 301.

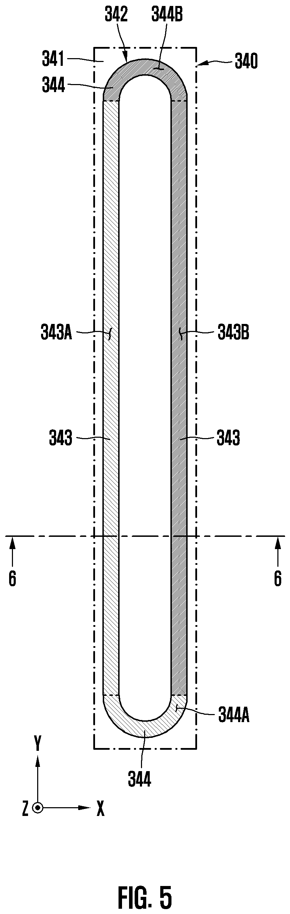

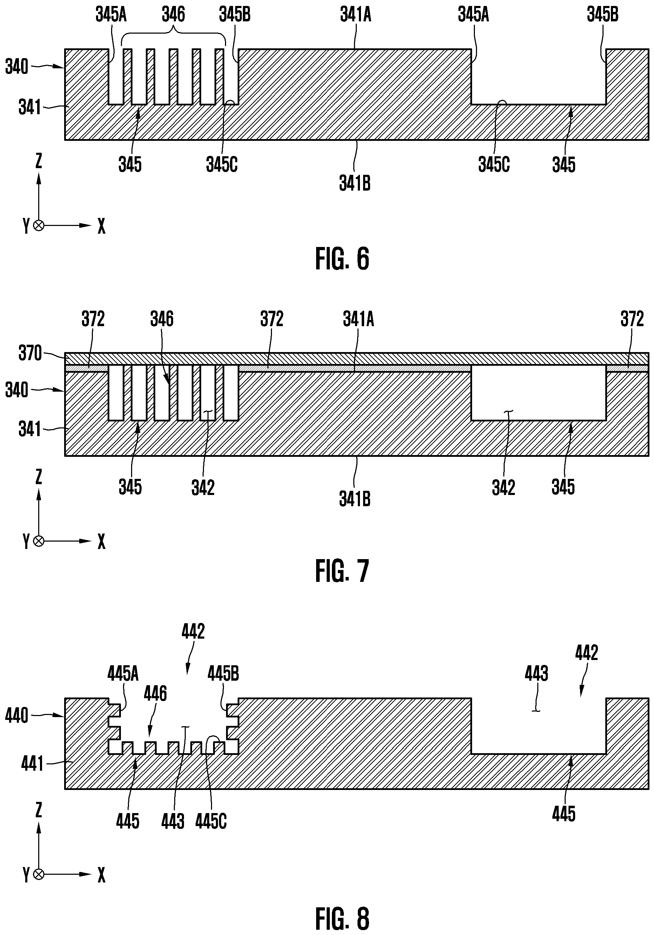

FIG. 5 is a plan view of channels of a frame structure, according to an embodiment. FIG. 6 is a cross-sectional view taken along a line 6-6 of the frame structure of FIG. 5, according to an embodiment.

Referring to FIGS. 5 and 6, the frame structure 340 may include the plate 341 and a flow path structure 342. The flow path structure 342 may include a plurality of first channels 343 arranged in a first direction (e.g., +/-X direction) of the plate 341 and a plurality of second channels 344 arranged in a second direction (e.g., +/-Y direction) of the plate 341 and connected to the plurality of first channels 343.

In an embodiment, the plurality of first channels 343 may extend in the second direction (e.g., +/-Y direction) of the plate 341. The plurality of first channels 343 may advance in a substantially linear manner. The plurality of first channels 343 may be substantially parallel to one another.

In an embodiment, the plurality of second channels 344 may extend in the first direction (e.g., +/-X direction) of the plate 341. The plurality of second channels 344 may be bent in the outward direction of the plate 341. The plurality of second channels 344 may have a substantially U-shape. The plurality of second channels 344 may be substantially symmetrical to one another.

In an embodiment, the plurality of first channels 343 and the plurality of second channels 344 may form a loop (e.g., a closed loop).

In an embodiment, the length of a first channel 343 may be substantially equal to or greater than the length of a second channel 344. In an embodiment, the length of the first channel 343 may be less than the length of the second channel 344.

In an embodiment, the plurality of first channels 343 and the plurality of second channels 344 may include a recess 345. The recess 345 may be formed in the thickness direction (e.g., -Z direction) of the plate 341. The recess 345 may be directed from a first surface 341A (e.g., the upper surface or +Z-axis direction) of the plate 341 to a second surface 341B (e.g., the lower surface or -Z-axis direction) opposite to the first surface 341A. The recess 345 may include a first recessed surface 345A intersecting (e.g., orthogonal to) the first surface 341A, a second recessed surface 345B intersecting (e.g., orthogonal to) the first surface 341A and opposite to the first recessed surface 345A, and a third recessed surface 345C substantially parallel to the first surface 341A and positioned between the first recessed surface 345A and the second recessed surface 345B. Meanwhile, the recess 345 is not limited to the shape described in the shown embodiment and may be implemented in various shapes. For example, the first recessed surface 345A may be inclined at a designated angle (e.g., about 45 degrees) with respect to the first surface 341A and/or the third recessed surface 345C. The second recessed surface 345B may be inclined at a designated angle (e.g., about 45 degrees) with respect to the first surface 341A and/or the third recessed surface 345C.

In an embodiment, the plurality of first channels 343 and the plurality of second channels 344 may include a plurality of regions guiding the flow of working fluids in different phases. The plurality of first channels 343 may include a first liquid region 343A that guides a working fluid in a liquid phase and a first gas region 343B that guides a working fluid in a gas phase. The plurality of second channels 344 may include a second liquid region 344A that guides the working fluid in the liquid phase and a second gas region 344B that guides the working fluid in the gas phase.

In an embodiment, the first liquid region 343A and the second liquid region 344A may be configured to transfer a working fluid in a liquid state condensed in a region of a flow path adjacent to a cooling portion of the electronic device 301. The first gas region 343B and the second gas region 344B may be configured to transfer a working fluid in a gaseous state vaporized in a region of a flow path adjacent to a heating portion of the electronic device 301.

In an embodiment, the first liquid region 343A and the second liquid region 344A may be connected to each other. The first gas region 343B and the second gas region 344B may be connected to each other. The first liquid region 343A and the second liquid region 344A may be separated from the first gas region 343B and the second gas region 344B. For example, depending on the state of the working fluid, the liquid regions 343A and 344A and the gas regions 343B and 344B may be spatially separated in the flow path structure 342. The working fluid may not substantially exist in a gas phase in the first liquid region 343A and the second liquid region 344A and may not substantially exist in a liquid phase in the first gas region 343B and the second gas region 344B. For example, the working fluid may not exist in different phases within a region of a channel but may exist in only one phase.

In an embodiment not shown, the plurality of first channels 343 and the plurality of second channels 344 may include at least one mixing region (not shown) in which the working fluid exists in a liquid state and a gaseous state. For example, the mixing region may be positioned between the liquid regions 343A and 344A and the gas regions 343B and 344B.

In an embodiment, the first liquid region 343A may be included in one first channel 343 (e.g., a channel disposed in the -X direction in FIG. 5) of the plurality of first channels 343, and the first gas region 343B may be included in another first channel 343 (e.g., a channel disposed in the +X direction in FIG. 5) of the plurality of first channels 343. The second liquid region 344A may be included in one second channel 344 (e.g., a channel disposed in the -Y direction in FIG. 5) of the plurality of second channels 344, and the second gas region 344B may be included in another second channel 344 (e.g., a channel disposed in the +Y direction in FIG. 5) of the plurality of second channels 344.

In an embodiment, the frame structure 340 may include a capillary structure 346 formed in the first liquid region 343A and the second liquid region 344A and configured to transfer the working fluid by capillary force. The capillary structure 346 may transfer the working fluid from the first liquid region 343A and the second liquid region 344A to the first gas region 343B and the second gas region 344B. For example, the capillary structure 346 may include a plurality of partitions arranged between the first recessed surface 345A and the second recessed surface 345B and extending from the third recessed surface 345C. A pair of adjacent partitions may form a microchannel. The plurality of partitions may extend in the extension direction of the first liquid region 343A and the second liquid region 344A.

In an embodiment, the frame structure 340 may include a superhydrophilic surface formed on the first liquid region 343A and the second liquid region 344A. The superhydrophilic surface may be formed on at least a portion of the first recessed surface 345A, at least a portion of the second recessed surface 345B, and/or at least a portion of the third recessed surface 345C. The superhydrophilic surface may increase the capillary force of the capillary structure 346.

FIG. 7 is a cross-sectional view of an electronic device including the frame structure of FIG. 6, according to an embodiment.

Referring to FIG. 7, the electronic device 301 may include the frame structure 340. The frame structure 340 may include the plate 341 and the plurality of flow path structures 342. The plate 341 may have the first surface 341A and the second surface 341B. The plurality of flow path structures 342 may each include the plurality of first channels 343 and the plurality of second channels 344, as illustrated in FIGS. 5 and 6. The frame structure 340 may include the recess 345 and the capillary structure 346.

**In** an embodiment, the electronic device 301 may include the cover sheet 370 disposed on the first surface 341A of the plate 341. The cover sheet 370 may substantially cover the entirety of the first surface 341A of the plate 341. The cover sheet 370 may seal the plurality of flow path structures 342.

In an embodiment, the electronic device 301 may include a bonding layer 372 configured to bond the plate 341 to the cover sheet 370. The bonding layer 372 may be disposed between the first surface 341A of the plate 341 and the cover sheet 370.

In an embodiment, the plate 341 and the cover sheet 370 may be bonded together by various bonding techniques. For example, the bonding techniques may include brazing, diffusion bonding, laser welding, and/or other bonding techniques.

In an embodiment, the bonding layer 372 may not be disposed on the plurality of flow path structures 342. The plurality of partitions of the capillary structure 346 may extend between the cover sheet 370 and a recessed surface (e.g., the third recessed surface 345C of FIG. 7) of the recess 345 in a direction (e.g., +Z direction) from the recessed surface toward the cover sheet 370.

FIG. 8 is a cross-sectional view of the frame structure of FIG. 5, according to an embodiment.

Referring to FIG. 8, a frame structure 440 (e.g., the frame structure 340 of FIGS. 3 to 7) may include a plate 441 (e.g., the plate 341 of FIGS. 3 to 7) and a plurality of flow path structures 442 (e.g., the flow path structures 342 of FIGS. 3 to 7). The plurality of flow path structures 442 may include a plurality of channels 443 (e.g., the first channels 343 and the second channels 344 of FIGS. 3 to 7).

In an embodiment, the frame structure 440 may include a recess 445 (e.g., the recess 345 of FIGS. 3 to 7) having a first recessed surface 445A (e.g., the first recessed surface 345A of FIGS. 3 to 7), a second recessed surface 445B (e.g., the second recessed surface 345B of FIGS. 3 to 7), and a third recessed surface 445C (e.g., the third recessed surface 345C of FIGS. 3 to 7).

In an embodiment, the frame structure 440 may include a capillary structure 446 (e.g., the capillary structure 346 of FIGS. 3 to 7). The capillary structure 446 may include a plurality of grooves formed in at least a portion of the first recessed surface 445A, at least a portion of the second recessed surface 445B, and/or at least a portion of the third recessed surface 445C. The plurality of grooves may be arranged to be spaced apart from one another within the recess 445. The plurality of grooves may extend in the extension direction (e.g., +/-Y direction) of the plurality of channels 443.

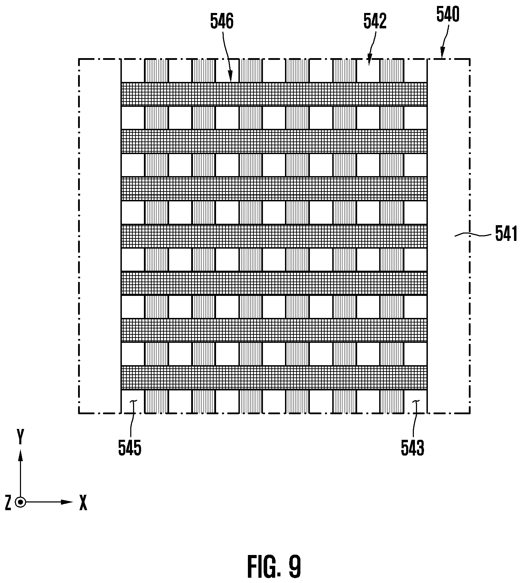

FIG. 9 is a plan view of the frame structure of FIG. 5, according to an embodiment.

Referring to FIG. 9, a frame structure 540 (e.g., the frame structure 340 of FIGS. 3 to 7) may include a plate 541 (e.g., the plate 341 of FIGS. 3 to 7) and a plurality of flow path structures 542 (e.g., the flow path structures 342 of FIGS. 3 to 7). The plurality of flow path structures 542 may each include a plurality of channels 543 (e.g., the first channels 343 and the second channels 344 of FIGS. 3 to 7). The frame structure 540 may include a recess 545 (e.g., the recess 345 of FIGS. 3 to 7) and a capillary structure 546 (e.g., the capillary structure 346 of FIGS. 3 to 7).

In an embodiment, the capillary structure 546 may include a mesh. The mesh may be disposed on a recessed surface (e.g., the third recessed surface 545C of FIGS. 3 to 7) of the recess 545. The mesh may extend in the extension direction (e.g., +/-Y direction) of the plurality of channels 543.

Meanwhile, the frame structure may include one of the capillary structures 346, 446, and 546 illustrated in FIGS. 7 to 9 but is not limited thereto and may include various combinations of capillary structures 346, 446, and 546. For example, the frame structure may include a plurality of partitions disposed in a partial region of a channel and a mesh disposed in another region of the channel.

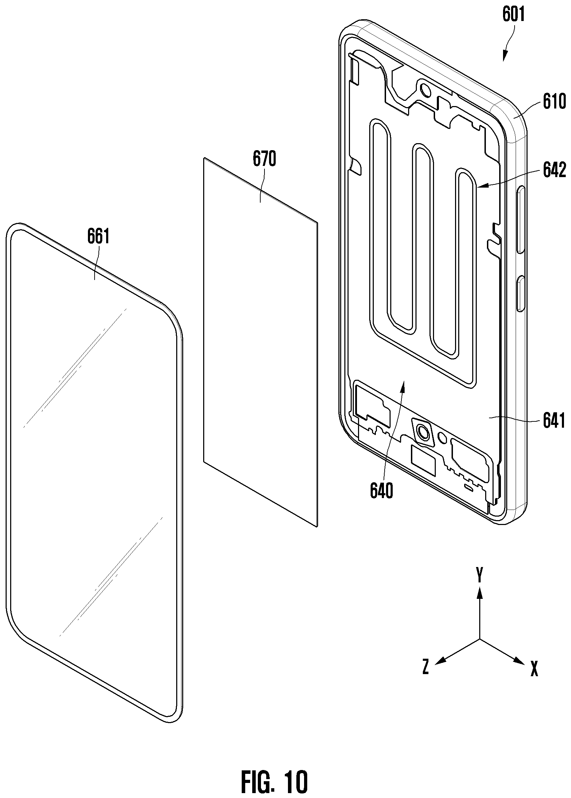

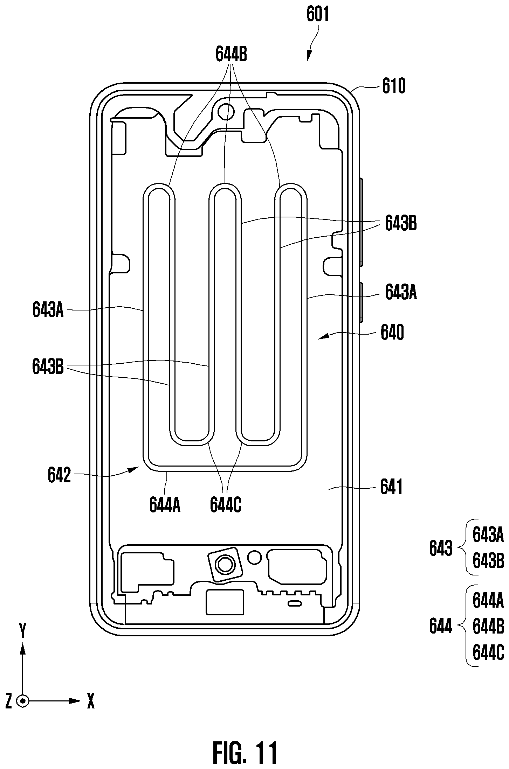

FIG. 10 is an exploded perspective view of an electronic device, according to an embodiment. FIG. 11 is a plan view of a frame structure of the electronic device, according to an embodiment.

Referring to FIGS. 10 and 11, an electronic device 601 (e.g., the electronic device 301 of FIGS. 3 to 7) may include a housing 610 (e.g., the housing 310 of FIGS. 3 to 7), a frame structure 640 (e.g., the frame structure 340 of FIGS. 3 to 7), a cover sheet 670 (e.g., the cover sheet 370 of FIGS. 3 to 7), and a display 661 (e.g., the display 361 of FIGS. 3 to 7). The frame structure 640 may include a plate 641 (e.g., the plate 341 of FIGS. 3 to 7) and a flow path structure 642 (e.g., the flow path structures 342 of FIGS. 3 to 7).

In an embodiment, the flow path structure 642 may be configured to diffuse heat within the plate 641. The flow path structure 642 may be a single flow path structure formed integrally with the plate 641.

In an embodiment, the flow path structure 642 may include a plurality of first channels 643 (e.g., the first channels 343 of FIGS. 3 to 7) and a plurality of second channels 644 (e.g., the second channels 344 of FIGS. 3 to 7).

In an embodiment, the plurality of first channels 643 may include first outer channels 643A and a plurality of first intermediate channels 643B.

In an embodiment, the first outer channels 643A may extend along a side edge of the plate 641 in one direction (e.g., +/-Y direction or second direction) of the plate 641. The first outer channels 643A may be formed in a substantially linear manner.

In an embodiment, the plurality of first intermediate channels 643B may extend in a second direction (e.g., +/-Y direction) of the plate 641. The plurality of first intermediate channels 643B may be arranged between the first outer channels 643A. The plurality of first intermediate channels 643B may be formed in a substantially linear manner.

In an embodiment, the length of a first outer channel 643A may be greater than the length of a first intermediate channel 643B.

In an embodiment, the plurality of second channels 644 may include a plurality of second outer channels 644A and 644B and at least one second intermediate channel 644C.

In an embodiment, one second outer channel 644A (e.g., a channel disposed in the -Y direction in FIG. 11) of the plurality of second outer channels 644A and 644B may link first ends (e.g., ends disposed in the -Y direction in FIG. 11) of the plurality of first outer channels 643A.

In an embodiment, one second outer channel 644A (e.g., a channel disposed in the -Y direction in FIG. 11) of the second outer channels 644A and 644B may extend in the first direction (e.g., +/-X direction) of the plate 641. The second outer channel 644A may be formed substantially in a linear manner.

In an embodiment, among the plurality of second outer channels 644A and 644B, a plurality of other second outer channels 644B (e.g., channels disposed in the +Y direction in FIG. 11) may connect second ends (e.g., ends disposed in the +Y direction in FIG. 11) opposite to the first ends of the plurality of first outer channels 643A to one end (e.g., an end disposed in the +Y direction in FIG. 11) of at least one first intermediate channel 643B.

In an embodiment, among the plurality of second outer channels 644A and 644B, a plurality of other second outer channels 644B (e.g., channels disposed in the +Y direction in FIG. 11) may extend in the first direction (e.g., +/-X direction) of the plate 641. The plurality of second outer channels 644B may be bent convexly in a direction (e.g., +Y direction) opposite to the direction (e.g., -Y direction) facing other second outer channels 644A.

In an embodiment, at least one second intermediate channel 644C may link the other ends (e.g., the ends disposed in the -Y direction in FIG. 11) of the plurality of first intermediate channels 643B.

In an embodiment, at least one second intermediate channel 644C may extend in the first direction (e.g., +/-X direction) of the plate 641. A second intermediate channel 644C may be bent convexly in a direction (e.g., -Y direction) facing a second outer channel 644A.

In an embodiment, the length of one second outer channel 644A may be greater than the length of the other second outer channel 644B. The length of one second outer channel 644A may be greater than the length of the second intermediate channel 644C. The length of another second outer channel 644B may be substantially equal to or less than the length of the second intermediate channel 644C. The length of one second outer channel 644B may be greater than the length of the second intermediate channel 644C.

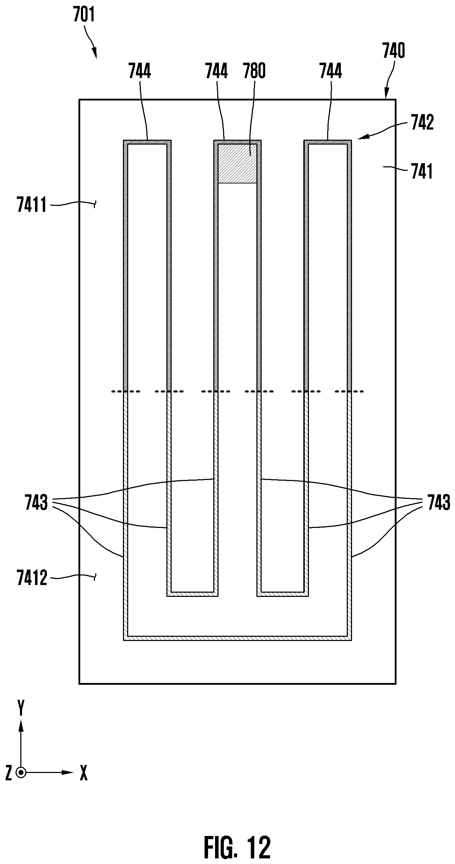

FIG. 12 is a diagram illustrating a frame structure in a first state of an electronic device, according to an embodiment.

Referring to FIG. 12, an electronic device 701 (e.g., the electronic device 601 of FIGS. 10 and 11) may include a frame structure 740 (e.g., the frame structure 640 of FIGS. 10 and 11). The frame structure 740 may include a plate 741 (e.g., the plate 641 of FIGS. 10 and 11) and a flow path structure 742 (e.g., the flow path structure 642 of FIGS. 10 and 11).

In an embodiment, the frame structure 740 may include the plate 741 (e.g., the plate 641 of FIGS. 10 and 11). The plate 741 may include a first portion 7411 (e.g., a high temperature portion) having a first temperature and a second portion 7412 (e.g., a low temperature portion) having a second temperature lower than the first temperature. A heat source 780 (e.g., the processor 120, the camera module 180, the power management module 188, the battery 189, and/or the antenna module 197 of FIG. 1) may be disposed close to the first portion 7411 and away from the second portion 7412.

In an embodiment, the flow path structure 742 may include a plurality of first channels 743 (e.g., the first channel 643 of FIGS. 10 and 11) and a plurality of second channels 744 (e.g., the second channel 644 of FIGS. 10 and 11).

In an embodiment, regions positioned on the first portion 7411 of the plate 741 among the plurality of first channels 743 and the plurality of second channels 744 may include a working fluid in a liquid state when the electronic device 701 is in a first state (e.g., an initial state). Regions positioned in the second portion 7412 of the plate 741 among the plurality of first channels 743 and the plurality of second channels 744 may include a working fluid in a gaseous state when the electronic device 701 is in the first state (e.g., the initial state).

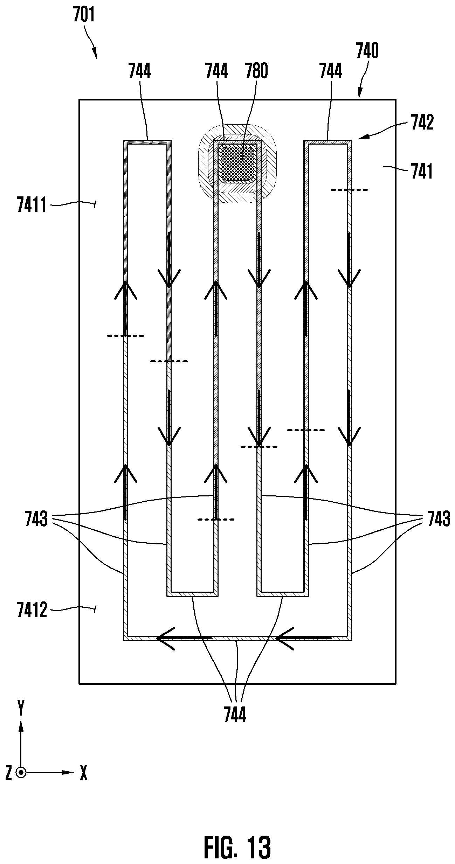

FIG. 13 is a diagram illustrating the frame structure when the electronic device is in a second state, according to an embodiment.

FIG. 13 illustrates the second state of the electronic device 701 after heat is generated from the heat source 780 and a predetermined amount of time elapses from the first state of the electronic device 701. In regions of the channels 743 and 744 positioned in the first portion 7411, the working fluid may undergo a phase change from liquid to gas. The internal pressure in the regions of the channels 743 and 744 positioned in the first portion 7411 may increase. The internal pressure of the regions of the channels 743 and 744 positioned in the first portion 7411 may be greater than the internal pressure of the regions of the channels 743 and 744 positioned in the second portion 7412. The pressure difference between the internal pressure of the regions of the channels 743 and 744 in the first portion 7411 and the internal pressure of the regions of the channels 743 and 744 in the second portion 7412 may force the transfer of a working fluid in a gas phase in the regions in the first portion 7411. The working fluid may be transferred to the regions of the channels 743 and 744 in the second portion 7412 through the channels 743 and 744. In the regions of the channels 743 and 744 in the second portion 7412, the working fluid may undergo a phase change from gas to liquid. The working fluid in a liquid phase may be transferred to the regions of the channels 743 and 744 in the first portion 7411 by the capillary force of the channels 743 and 744. The working fluid circulates through the channels 743 and 744 while undergoing a phase change between liquid and gas and may exchange heat with at least one component.

One aspect of the disclosure may provide a frame structure integrated with a cooling structure and an electronic device including the frame structure. However, the goals to be achieved are not limited to those described above and may be expanded in various manners within the scope without departing from the spirit and field of the disclosure.

According to an embodiment, an electronic device 101, 201, 301, 601, 701 may include a frame structure 241, 243, 340, 440, 540, 640, 740. The electronic device 101, 201, 301, 601, 701 may include a housing 210, 310. The housing 210, 310 may be configured to accommodate a frame structure 241, 243, 340, 440, 540, 640, 740.

**In** an embodiment, the frame structure 241, 243, 340, 440, 540, 640, 740 may include a plate 341, 441, 541, 641, 741 having a first length, a second length, and a thickness.

**In** an embodiment, the frame structure 241, 243, 340, 440, 540, 640, 740 may include a plurality of first channels 343, 443, 543, 643, 743. The plurality of first channels 343, 443, 543, 643, 743 may be recessed in the thickness direction on one surface of the plate 341, 441, 541, 641, 741. The plurality of first channels 343, 443, 543, 643, 743 may be arranged in a first longitudinal direction of the plate 341, 441, 541, 641, 741. The plurality of first channels 343, 443, 543, 643, 743 may be configured to guide the flow of a working fluid.

In an embodiment, the frame structure 241, 243, 340, 440, 540, 640, 740 may include a plurality of second channels 344, 644, 744. The plurality of second channels 344, 644, 744 may be recessed in the thickness direction in one surface of the plate 341, 441, 541, 641, 741. The plurality of second channels 344, 644, 744 may be arranged in a second longitudinal direction of the plate 341, 441, 541, 641, 741. The plurality of second channels 344, 644, 744 may be connected to the plurality of first channels 343, 443, 543, 643, 743. The plurality of second channels 344, 644, 744 may be configured to guide the flow of the working fluid.

In an embodiment, the plurality of first channels 343, 443, 543, 643, 743 and the plurality of second channels 344, 644, 744 may form a closed loop within the plate 341, 441, 541, 641, 741.

In an embodiment, the plurality of first channels 343, 443, 543, 643, 743 may include a first liquid region 343A configured to guide a working fluid in a liquid phase.

In an embodiment, the plurality of first channels 343, 443, 543, 643, 743 may include a first gas region 343B configured to guide a working fluid in a gas phase.

In an embodiment, the plurality of first channels 343, 443, 543, 643, 743 and the plurality of second channels 344, 644, 744 may form a plurality of closed loops.

In an embodiment, at least one first channel among the plurality of first channels 343, 443, 543, 643, 743 may extend linearly in the second longitudinal direction of the plate 341, 441, 541, 641, 741.

In an embodiment, at least one second channel among the plurality of second channels 344, 644, 744 may be bent convexly in the second longitudinal direction of the plate 341, 441, 541, 641, 741.

In an embodiment, the plurality of first channels 343, 443, 543, 643, 743 may include a capillary structure 346, 446, 546. The capillary structure 346, 446, 546 may be positioned in a first liquid region 343A. The capillary structure 346, 446, 546 may be configured to transfer a working fluid.

In an embodiment, the capillary structure 346 may include at least one partition. At least one partition may form a plurality of microchannels.

In an embodiment, the capillary structure 446 may include at least one groove. At least one groove may be formed in recessed surfaces 345A, 345B, 345C of the plurality of first channels.

In an embodiment, the capillary structure 546 may include a mesh. The mesh may be disposed on a recessed surface 345C of the plurality of first channels.

In an embodiment, the plurality of first channels 343, 443, 543, 643, 743 may include a superhydrophilic surface. The superhydrophilic surface may be formed on at least a portion of the recessed surfaces 345A, 345B, 345C of a first liquid region 343A.

In an embodiment, the plurality of second channels 344, 644, 744 may include a second liquid region 344A configured to guide the working fluid in the liquid phase. The second liquid region 344A may be connected to the first liquid region 343A. The plurality of second channels 344, 644, 744 may include a second gas region 344B configured to guide the working fluid in the gas phase. The second gas region 344B may be connected to the first gas region 343B.

In an embodiment, the plurality of first channels 343 443, 543, 643, 743 and the plurality of second channels 344, 644, 744 may be formed integrally with the plate 341, 441, 541, 641, 741.

In an embodiment, the plurality of first channels 343, 443, 543, 643, 743 and the plurality of second channels 344, 644, 744 may form a single loop.

In an embodiment, at least one second channel among the plurality of second channels 344, 644, 744 may extend linearly in the first longitudinal direction of the plate 341, 441, 541, 641, 741.

In an embodiment, the length of one second channel among the plurality of second channels 344, 644, 744 may be greater than the length of another second channel.

In an embodiment, the electronic device 101, 201, 301, 601, 701 may include a cover sheet 370. The cover sheet 370 may be disposed on the plate 341, 441, 541, 641, 741. The cover sheet 370 may be configured to cover the plurality of first channels 343, 443, 543, 643, 743 and the plurality of second channels 344, 644, 744.

In an embodiment, the electronic device 101, 201, 301, 601, 701 may include a bonding layer 372. The bonding layer 372 may be configured to bond the plate 341, 441, 541, 641, 741 to the cover sheet 370.

In an embodiment, the frame structure 241, 243, 340, 440, 540, 640, 740 may include a first portion 7411 having a first temperature and a second portion 7412 having a second temperature. The second temperature may be lower than the first temperature.

According to an embodiment, the thickness of the frame structure may be reduced, and the thickness of an electronic device to which the frame structure is applied may be reduced.

According to an embodiment, the rigidity of the frame structure may be increased.

The effects of the frame structure and the electronic device including the same according to one or more embodiments are not limited to the above-mentioned effects, and other unmentioned effects may be clearly understood from the following description by one of ordinary skill in the art.

The embodiments of the disclosure are intended to be illustrative and not restrictive. Various modifications may be made to the detailed description of the disclosure including the accompanying scope of claims and equivalents. Any of the embodiment(s) described herein may be used in combination with any other embodiment(s) described herein.

## Claims

1. An electronic device (101; 201; 301; 601; 701) comprising:
a frame structure (241, 243; 340; 440; 540; 640; 740); and
a housing (210; 310) configured to accommodate the frame structure (241, 243; 340; 440; 540; 640; 740),
wherein the frame structure (241, 243; 340; 440; 540; 640; 740) comprises:
a plate (341; 441; 541; 641; 741) comprising a first length, a second length, and a thickness;
a plurality of first channels (343; 443; 543; 643; 743) recessed in a surface of the plate (341; 441; 541; 641; 741) in a thickness direction, and arranged in a first longitudinal direction of the plate (341; 441; 541; 641; 741), the plurality of first channels being configured to guide a flow of a working fluid; and
a plurality of second channels (344; 644; 744) recessed in the surface of the plate (341; 441; 541; 641; 741) in the thickness direction, and arranged in a second longitudinal direction of the plate (341; 441; 541; 641; 741), the plurality of second channels being configured to guide the flow of the working fluid,
wherein the plurality of first channels (343; 443; 543; 643; 743) are connected to the plurality of second channels (344; 644; 744) to form a closed loop within the plate (341; 441; 541; 641; 741), and
wherein the plurality of first channels (343; 443; 543; 643; 743) comprises:
a first liquid region (343A) configured to guide the working fluid in a liquid phase; and
a first gas region (343B) configured to guide the working fluid in a gas phase.

2. The electronic device of claim 1, wherein the plurality of first channels (343; 443; 543; 643; 743) are connected to the plurality of second channels (344; 644; 744) to form a plurality of closed loops.

3. The electronic device of claim 1 or 2, wherein at least one first channel among the plurality of first channels (343; 443; 543; 643; 743) extends linearly in the second longitudinal direction of the plate (341; 441; 541; 641; 741).

4. The electronic device of any one of claims 1 to 3, wherein at least one second channel among the plurality of second channels (344; 644; 744) is bent convexly in the second longitudinal direction of the plate (341; 441; 541; 641; 741).

5. The electronic device of any one of claims 1 to 4, wherein the plurality of first channels (343; 443; 543; 643; 743) further comprises a capillary structure (346; 446; 546) in the first liquid region (343A) and configured to transfer the working fluid.

6. The electronic device of any one of claims 1 to 5, wherein
the capillary structure (346) comprises at least one partition configured to form a plurality of microchannels,
the capillary structure (446) comprises at least one groove in a surface (345A, 345B, 345C) of the plurality of first channels, and/or
the capillary structure (546) comprises a mesh disposed on the recessed surface (345C) of the plurality of first channels.

7. The electronic device of any one of claims 1 to 6, wherein the plurality of first channels (343; 443; 543; 643; 743) further comprises a superhydrophilic surface on at least a portion of the surface (345A, 345B, 345C) of the first liquid region (343A).

8. The electronic device of any one of claims 1 to 7, wherein the plurality of second channels (344; 644; 744) comprises:
a second liquid region (344A) configured to guide the working fluid in the liquid phase and connected to the first liquid region (343A); and
a second gas region (344B) configured to guide the working fluid in the gas phase and connected to the first gas region (343B).

9. The electronic device of any one of claims 1 to 8, wherein the plurality of first channels (343; 443; 543; 643; 743) and the plurality of second channels (344; 644; 744) are integral with the plate (341; 441; 541; 641; 741).

10. The electronic device of any one of claims 1 to 9, wherein the plurality of first channels (343; 443; 543; 643; 743) are connected to the plurality of second channels (344; 644; 744) to form a single loop.

11. The electronic device of any one of claims 1 to 10, wherein at least one second channel among the plurality of second channels (344; 644; 744) extends linearly in the first longitudinal direction of the plate (341; 441; 541; 641; 741).

12. The electronic device of any one of claims 1 to 11, wherein a length of a second channel among the plurality of second channels (344; 644; 744) is greater than a length of another second channel among the plurality of second channels.

13. The electronic device of any one of claims 1 to 12, further comprising:
a cover sheet (370) disposed on the plate (341; 441; 541; 641; 741) and covering the plurality of first channels (343; 443; 543; 643; 743) and the plurality of second channels (344; 644; 744).

14. The electronic device of any one of claims 1 to 13, further comprising:
a bonding layer (372) bonding the plate (341; 441; 541; 641; 741) to the cover sheet (370).

15. The electronic device of any one of claims 1 to 14, wherein the frame structure (241, 243; 340; 440; 540; 640; 740) comprises:
a first portion (7411) configured to have a first temperature; and
a second portion (7412) configured to have a second temperature that is lower than the first temperature.
